# EUROPEAN PATENT SPECIFICATION

(11) **EP 1 026 748 B1**
(45) Date of publication and mention of the grant of the patent: **16.11.2005**
(21) Application number: 99300868.9
(22) Date of filing: 05.02.1999
(51) Int. Cl.: H01L 27/146

(54) **Method of manufacturing an active pixel pinned photodiode**
Herstellungsverfahren eines aktiven Pixelbildsensors mit einer Fotodiode vom Typ befestigende Schicht
Méthode de fabrication de un capteur à pixel actif avec une photodiode attachante

(43) Date of publication of application: 09.08.2000
(73) Proprietor: OmniVision Technologies, Inc., Sunnyvale, California 94089 (US)
(72) Inventor: Chen, Datong, Fremont, California 94555 (US)
(74) Representative: Carter, Stephen John

(56) References cited:
- EP-A- 0 854 516
- US-A- 5 625 210

## Description

The present invention relates to image sensing devices, and more particularly, to an active pixel pinned photodiode imaging array.

Integrated circuit implementations of imaging arrays have undergone significant development over the past twenty years. One widely used technology in the pixels of imaging arrays is the charged coupled device (CCD). The CCD device has been made popular by its oftentimes superior performance characteristics. However, one drawback of the CCD image sensor is that signal processing elements cannot be manufactured using the same process that is used to manufacture CCD devices. Therefore, signal processing circuitry must be located in a separate integrated circuit.

Another class of image sensors are the active pixel sensors. As noted in U.S. Patent No. 5,625,210 to Lee et al. ("the '210 patent), an active pixel sensor refers to electronic image sensors within active devices, such as transistors, that are associated with each pixel. The active pixel sensor has the advantage of being able to incorporate both signal processing and sensing circuitry within the same integrated circuit. Conventional active pixel sensors typically employ polysilicon photocapacitors or photodiodes as the active image sensing elements.

A device known as a pinned photodiode has gained favor for its ability to have good color response for blue light, as well as advantages in dark current density and image lag. While the '210 patent provides a method for using a pinned photodiode and an active pixel sensor, the design taught in the '210 patent suffers from the drawback of manufacturing complexity. In particular, as seen in the diagrams of the '210 patent, the manufacturer of such an apparatus requires multiple masking and photolithography steps.

Thus, what is needed, is a method of manufacturing a device having the advantages of an active pixel pinned photodiode as in the '210 patent with a minimum number of photolithography and masking steps. Alternatively stated, what is needed is a new pinned photodiode active pixel structure that can be more easily manufactured.

The present invention provides a method of manufacturing an active pixel in a semiconductor substrate, as set forth in Claim 1.

The active pixel comprises: a pinned photodiode formed in the semiconductor substrate; a transfer well having a second conductivity type formed in said substrate, said transfer well adjacent to the pinned photodiode; a transfer gate adjacent the transfer well, the transfer gate for controlling the flow of a signal charge from the pinned photodiode through the transfer well and under the transfer gate; and an output well adjacent the transfer gate for receiving the signal charge and routing the signal charge to output circuitry.

Preferably, the first conductivity type is p-type and the second conductivity type is n-type.

The active pixel may further include: a reset gate adjacent to said output well and a supply voltage well adjacent to said reset gate.

The pinned photodiode may be formed by a deep well in the substrate having the second conductivity type and a shallow well atop the deep well, the shallow well having the first conductivity type.

The foregoing aspects and many of the attendant advantages of this invention will become more readily appreciated as the same becomes better understood by reference to the following detailed description of an exemplary embodiment, when taken in conjunction with tne accompanying drawings, wherein:

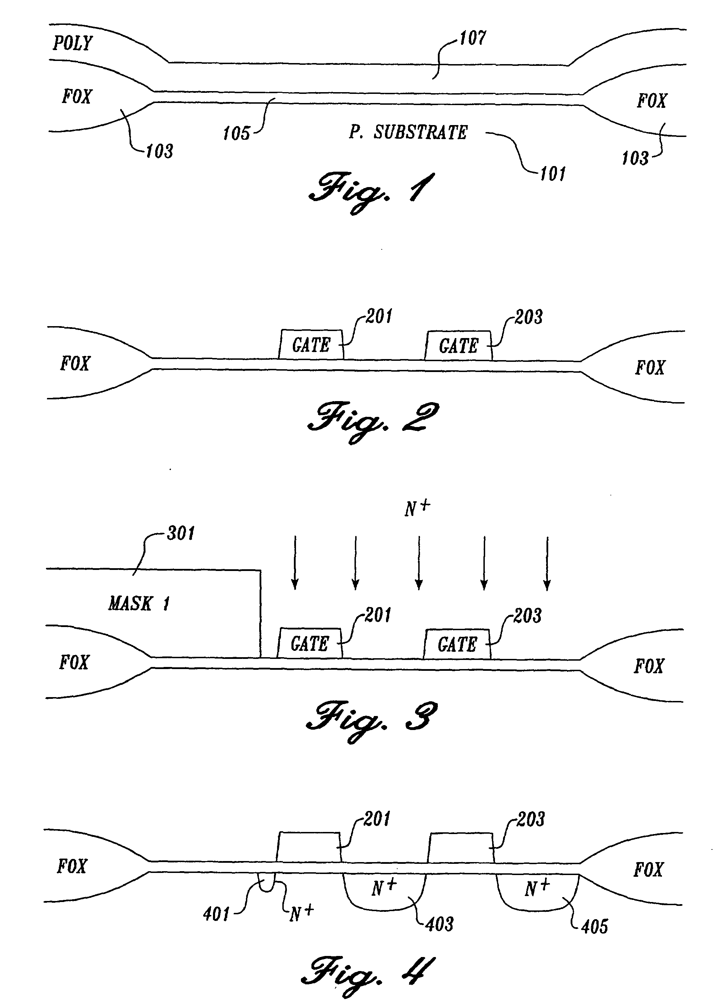

FIGURES 1-7 are schematic diagrams of the steps in manufacturing an active pixel having a pinned photodiode in accordance with the present invention.

The described embodiment is an improvement to the active pixel sensor taught in the '210 patent. Thus, much of the description of the operation and circuitry of an active pixel sensor is recited therein, as well as in the references noted in the '210 patent. For brevity, the description will not be repeated herein.

Turning first to FIGURE 1, a p-type semiconductor substrate 101 is provided. Field oxide regions 103 are formed in the substrate 101 using any suitable conventional semiconductor processing method, such as LOCOS. The field oxide regions 103 define an active area in which the pinned photodiode is formed. Also formed on top of the substrate 101 between the field oxide regions 103 is an isolation oxide 105. The isolation oxide 105 is also referred to as a gate oxide and is preferably formed from silicon dioxide. The method that is used to form the silicon dioxide isolation oxide layer 105 can be one of any well-known techniques including the thermal oxidation of silicon. Additionally, a layer of polysilicon 107 is deposited over the substrate 101. The polysilicon may be deposited using any conventional technique such as low pressure chemical vapor deposition (LPCVD).

Next, as seen in FIGURE 2, the polysilicon layer 107 is patterned and etched using conventional photolithography and masking techniques to form the control gates used in reading out the signal from the active pixel. In this embodiment, a transfer gate 201 is formed and a reset gate 203 is formed.

Next, turning to FIGURE 3, a first photolithography mask 301 is deposited onto a portion of the active region leaving exposed the transfer gate 201 and the reset gate 203. The mask 301 is formed using conventional photolithography techniques. Note that the first mask 301 does not extend to the transfer gate 201, but stops short of the transfer gate 201. In the preferred embodiment, the first mask 301 leaves a distance of approximately 0.2-0.5 microns to the transfer gate 201.

Next, an N⁺ ion implant is performed using the first mask 301 as an implantation mask. The implantation of the N⁺ is performed using known techniques in the prior art and conventional dopants. The resulting structure is shown in FIGURE 4 where three N⁺ wells 401, 403 and 405 are formed.

Next, in FIGURE 5, a second mask 501 is deposited onto the structure so that the second mask 501 covers nearly all of the active region that was previously left exposed by the first mask 301. Note that in the preferred embodiment, the second mask 501 does not extend completely to the edge of the N⁺ well 401, but rather just short of the edge. This allows a greater margin of error in the alignment of the second mask 501. It can be appreciated that the N⁺ well 401 must be in conductive contact with the later formed photodiode. If the second mask 501 extends beyond the N⁺ well 401, then there will be a non-conductive gap between the photodiode and the N⁺well 401. Thus, by providing the second mask 501 such that it nominally does not extend to the edge of the N⁺ well 401, a greater error margin is provided.

Next, by using sequential implants, a pinned photodiode may be constructed. A first ion implant is performed to create a photodiode by implanting a deep N well impurity. The N well implant is preferably deeper than the previous N⁺ wells that were formed in FIGURE 4. This deeper implant yields substantial increases in photo response due to an increased collection path for the instant photocarriers with the deeper implant. Next, a P⁺ implant (known as a pinning layer) is then made using high doses of low energy P⁺ dopant. This forms a shallow P⁺ well near the surface of the substrate. The resultant structure is shown in FIGURE 6.

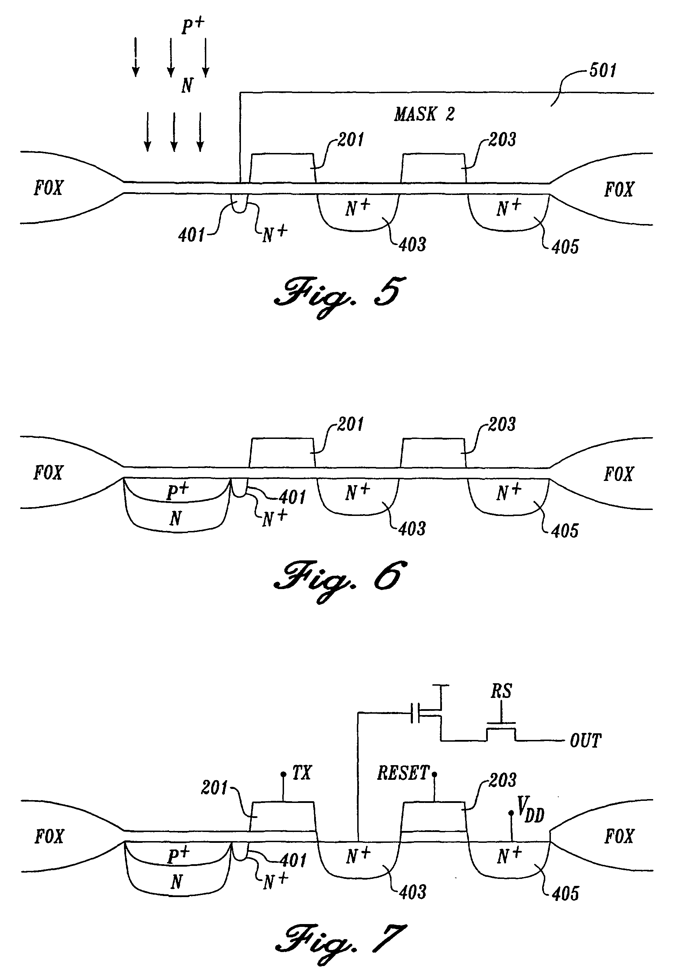

Finally, as seen in FIGURE 7, a conventional masking and etching step is used to remove the gate oxide above the source and drain N⁺ wells 403 and 405. As further described in the '210 patent and as seen in FIGURE 7, the N⁺ well 403 is connected to output circuitry that can readout the signal from the pinned photodiode. The N⁺ well 403 is also referred to as the output well. The N⁺ well 405 is connected to a supply voltage V_{dd}. The reset gate 203 is periodically activated by a reset signal. When the reset signal is "on", then the channel under the reset gate 203 is conducting and both N⁺ wells 403 and 405 are equalized at the voltage V_{dd}.

The present invention provides a active pixel pinned photodiode structure that can be made with one less mask than the structure taught in the '210 patent. This is accomplished by removing the need for an N⁻ channel underneath the transfer gate as in the '210 patent. Instead, a highly doped N⁺ well 401 (a "transfer well") adjacent to the transfer gate 201 is formed that aids in the transfer of charge (the photo signal) from the pinned photodiode to the output circuitry. Another advantage of the present invention is that the masking steps shown in the '210 patent to form the lightly doped N- channel underneath the transfer gate must be precisely aligned to be underneath the transfer gate. In contrast, the alignment of the mask in the present invention is relatively robust to misalignment.

## Claims

1. A method of manufacturing an active pixel in a semiconductor substrate having a first conductivity type, said active pixel formed in an active region of said semiconductor substrate, said method comprising the steps of:
(a) forming a gate oxide layer on said active region of said substrate;
(b) forming a conductive layer on said gate oxide layer;
(c) masking and etching said conductive layer to form a transfer gate and a reset gate atop said gate oxide layer;
(d) masking a portion of said active region not including said transfer gate and said reset gate and implanting impurities into said substrate to transform said first conductivity type to a second conductivity type to form a transfer well adjacent said transfer gate, an output well between said transfer gate and said reset gate, and a supply well adjacent said reset gate; and
(e) masking those portions of said active region left unmasked in step (d) and forming a pinned photodiode adjacent said transfer well.

2. The method of Claim 1 wherein said conductive layer is polysilicon.

3. The method of claim 1 or 2 wherein said first conductivity type is p-type and said second conductivity type is n-type.

4. The method of any one of claims 1 to 3 further including the step of removing said gate oxide layer that is over said output well and said supply well.

5. The method of any one of claims 1 to 4 wherein the step of forming a pinned photodiode comprises the steps of using an ion implant to form a deep well of said second conductivity type and a shallow well atop said deep well of said first conductivity type.

6. The method of Claim 5 further including the step of removing said gate oxide layer that is over said output well and said supply well.

7. The method of any one of claims 1 to 6 wherein the mask of step (e) does not extend over all ot said active region left unmasked in step (d).

## Patentansprüche

1. Verfahren zur Herstellung eines aktiven Pixel in einem Halbleitersubstrat, das einen ersten Typ Leitfähigkeit aufweist, wobei das aktive Pixel in einem aktiven Bereich des Halbleitersubstrats gebildet wird, wobei das Verfahren die folgenden Schritte umfasst:
(a) das Ausbilden einer Gate-Oxidschicht auf dem aktiven Bereich des Substrats;
(b) das Ausbilden einer leitenden Schicht auf der Gate-Oxidschicht;
(c) das Maskieren und Ätzen der leitenden Schicht, um auf der Gate-Oxidschicht ein Transfer-Gate und ein Rücksetz-Gate auszubilden;
(d) das Maskieren eines Abschnitts des aktiven Bereichs, der das Transfer-Gate und das Rücksetz-Gate nicht umfasst, und das Einbringen von Störstellen in das Substrat, um den ersten Typ Leitfähigkeit in einen zweiten Typ Leitfähigkeit umzuwandeln, um angrenzend an das Transfer-Gate einen Transfer-Topf, zwischen dem Transfer-Gate und dem Rücksetz-Gate einen Ausgangs-Topf und angrenzend an das Rücksetz-Gate einen Versorgungs-Topf auszubilden; und
(e) das Maskieren jener Abschnitte des aktiven Bereichs, die in Schritt (d) nicht maskiert wurden, und das Ausbilden einer Pinned-Photodiode angrenzend an den Transfer-Topf.

2. Verfahren nach Anspruch 1, worin die leitende Schicht Polysilicium ist.

3. Verfahren nach Anspruch 1 oder 2, worin der erste Typ Leitfähigkeit der p-Typ und der zweite Typ Leitfähigkeit der n-Typ ist.

4. Verfahren nach einem der Ansprüche 1 bis 3, weiters umfassend den Schritt des Entfernens der Gate-Oxidschicht, die über dem Ausgangs-Topf und dem Versorgungs-Topf liegt.

5. Verfahren nach einem der Ansprüche 1 bis 4, worin der Schritt des Ausbildens einer Pinned-Photodiode den Schritt des Verwendens eines Ionenimplantats zur Ausbildung eines tiefen Topfes des zweiten Typs Leitfähigkeit und eines flachen Topfes über dem tiefen Topf des ersten Typs Leitfähigkeit umfasst.

6. Verfahren nach Anspruch 5, weiters umfassend den Schritt des Entfernens der Gate-Oxidschicht, die über dem Ausgangs-Topf und dem Versorgungs-Topf liegt.

7. Verfahren nach einem der Ansprüche 1 bis 6, worin die Maske aus Schritt (e) nicht den gesamten aktiven Bereich abdeckt, der in Schritt (d) nicht maskiert wurde.

## Revendications

1. Procédé de fabrication d'un pixel actif dans un substrat semi-conducteur ayant un premier type de conductivité, ledit pixel actif étant formé dans une région active dudit substrat semi-conducteur, ledit procédé comprenant les étapes de :
(a) formation d'une couche d'oxyde de grille sur ladite région active dudit substrat ;
(b) formation d'une couche conductrice sur ladite couche d'oxyde de grille ;
(c) masquage et attaque de ladite couche conductrice pour former une grille de transfert et une grille de réinitialisation au-dessus de ladite couche d'oxyde de grille ;
(d) masquage d'une partie de ladite région active ne comprenant pas ladite grille de transfert et ladite grille de réinitialisation et implantation d'impuretés dans ledit substrat pour transformer ledit premier type de conductivité en un second type de conductivité pour former un puits de transfert adjacent à ladite grille de transfert, un puits de sortie entre ladite grille de transfert et ladite grille de réinitialisation, et un puits d'alimentation adjacent à ladite grille de réinitialisation ; et
(e) masquage des parties de ladite région active laissées non masquées dans l'étape (d) et formation d'une photodiode à broche adjacente audit puits de transfert.

2. Procédé de la revendication 1 dans lequel ladite couche conductrice est en polysilicium.

3. Procédé de la revendication 1 ou 2 dans lequel ledit premier type de conductivité est le type p et ledit second type de conductivité est le type n.

4. Procédé de l'une quelconque des revendications 1 à 3 comprenant en outre l'étape d'élimination de ladite couche d'oxyde de grille qui est au-dessus dudit puits de sortie et dudit puits d'alimentation.

5. Procédé de l'une quelconque des revendications 1 à 4 dans lequel l'étape de formation d'une photodiode à broche comprend les étapes d'utilisation d'une implantation ionique pour former un puits profond dudit second type de conductivité et un puits peu profond au-dessus dudit puits profond dudit premier type de conductivité.

6. Procédé de la revendication 5 comprenant en outre l'étape d'élimination de ladite couche d'oxyde de grille qui est au-dessus dudit puits de sortie et dudit puits d'alimentation.

7. Procédé de l'une quelconque des revendications 1 à 6 dans lequel le masque de l'étape (e) ne s'étend pas au-dessus de toute ladite région active laissée non masquée dans l'étape (d).
